Europäisches Patentamt

European Patent Office

Office européen des brevets

(11) Veröffentlichungsnummer: **0 394 508**

**A1**

(12) **EUROPÄISCHE PATENTANMELDUNG**

(21) Anmeldenummer: 89107387.6

(22) Anmeldetag: 24.04.89

(51) Int. Cl.5: **G01R 33/34**

(43) Veröffentlichungstag der Anmeldung:
**31.10.90 Patentblatt 90/44**

(84) Benannte Vertragsstaaten:
**DE FR GB**

(71) Anmelder: **Siemens Aktiengesellschaft**
**Wittelsbacherplatz 2**
**D-8000 München 2(DE)**

(72) Erfinder: **Requardt, Hermann, Dr. phil. nat.**
**Hofmannstrasse 107**
**D-8520 Erlangen(DE)**
Erfinder: **Krause, Nobert, Dr. Ing.**
**Weinbergstrasse 29**
**D-8551 Heroldsbach(DE)**

(54) Oberflächenspule für ein Kernspin-Resonanzgerät.

(57) Die erfindungsgemäße Oberflächenspule besteht aus mehreren Leiterabschnitten (19a-19g), die über Schalter (22-31) so miteinander und mit einer Empfangseinheit (21) verbindbar sind, daß die je nach Stellung der Schalter (22-31) mit der Empfangseinheit (21) verbundenen Leiterabschnitte (19a-19g) unterschiedliche Flächen einschließen. Die äußere Kontur der Oberflächenspule ist dabei so gestaltet, daß die von ihr insgesamt umfaßte Fläche eine Breite aufweist, die sich über die Länge der Oberflächenspule (19) ändert. Damit kann die Oberflächenspule bei Untersuchungsobjekten, die einen über die Länge der Oberflächenspule veränderlichen Abstand von der Untersuchungsoberfläche aufweisen, so ausgeführt werden, daß jeder Teil des Untersuchungsobjektes mit maximalem Signal-Rausch-Verhältnis abgebildet wird.

FIG 4

EP 0 394 508 A1

## Oberflächenspule für ein Kernspin-Resonanzgerät

Die Erfindung betrifft eine Oberflächenspule für ein Kernspin-Resonanzgerät zur Ermittlung von Spektren oder Bildern mittels der kernmagnetischen Resonanz mit Spulen zum Anlegen von magnetischen Grund- und Gradientenfeldern an ein Untersuchungsobjekt und mit einer Antenne, mit der das Untersuchungsobjekt mit einer Folge von Hochfrequenzimpulsen bestrahlt wird, wobei die vom Untersuchungsobjekt ausgesandten Kernresonanzsignale mit einer Oberflächenspule erfaßt werden, die an eine Auswerteschaltung angeschlossen ist und wobei die Oberflächenspule aus mehreren Leiterabschnitten besteht, die über Schalter so miteinander und mit der Abstimmeinheit verbindbar sind, daß die je nach Stellung der Schalter mit der Abstimmeinheit verbundenen Leiterabschnitte unterschiedliche Flächen einschließen.

Eine solche Oberflächenspule ist beispielsweise aus der EP-A1-0 280 908 bekannt. Mit dieser Oberflächenspule kann die wirksame Fläche durch entsprechende Stellung der Schalter an die jeweiligen Erfordernisse (großer Untersuchungsbereich bei geringer Auflösung oder kleiner Untersuchungsbereich bei höherer Auflösung) angepaßt werden. Außerdem kann die Lage des Untersuchungsbereiches verändert werden. Die letztere Eigenschaft ist z.B. von Vorteil, wenn die Wirbelsäule untersucht werden soll. In diesem Fall kann dann der aktive Teil der Oberflächenspule entlang der Wirbelsäule fortgeschaltet werden.

Aufgabe der Erfindung ist es, die eingangs genannte Oberflächenspule insbesondere für die Untersuchung der Wirbelsäule weiter zu verbessern.

Diese Aufgabe wird erfindungsgemäß dadurch gelöst, daß die von der Oberflächenspule insgesamt umfaßte Fläche eine Breite aufweist, die sich über die Länge der Oberflächenspule verändert. Damit kann man die Geometrie der Oberflächenspule an den unterschiedlichen Abstand der Wirbelsäule von der Untersuchungsoberfläche anpassen und damit jeden Teil der Wirbelsäule mit maximalem Signal-Rausch-Verhältnis abbilden.

Vorteilhafte Ausgestaltungen der Erfindung sind in den Unteransprüchen angegeben.

Ausführungsbeispiele der Erfindung werden nachfolgend anhand der Figuren 1 bis 6 näher erläutert.

Fig. 1 zeigt schematisch den Aufbau eines Kernspin-Resonanzgerätes,

Fig. 2 zeigt den Verlauf des Signal-Rausch-Verhältnisses in Abhängigkeit vom Abstand Oberflächenspule-Untersuchungsbereich für zwei verschiedene Spulengrößen,

Fig. 3 zeigt schematisch den Verlauf der Wirbelsäule im Körper,

Fig. 4 zeigt schematisch ein erstes Ausführungsbeispiel der erfindungsgemäßen Oberflächenspule,

Fig. 5 zeigt schematisch ein zweites Ausführungsbeispiel der erfindungsgemäßen Oberflächenspule,

Fig. 6 zeigt ein Ausführungsbeispiel für die Anordnung von Schaltern innerhalb der Oberflächenspule.

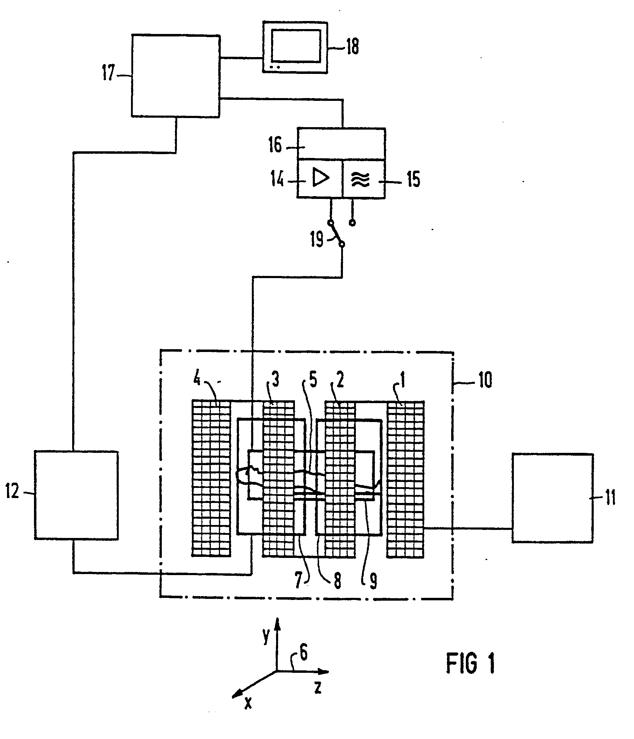

Bei dem in Fig. 1 dargestellten prinzipiellen Aufbau eines Kernspin-Resonanzgerätes zur Ermittlung von Bildern oder Spektren eines Untersuchungsobjektes sind mit 1 und 2 sowie 3 und 4 Spulen bezeichnet, die ein magnetisches Grundfeld $B_0$ erzeugen, in welchem sich der zu untersuchende Körper 5 eines Patienten befindet. Diesem sind außerdem Gradientenspulen zugeordnet, die zur Erzeugung unabhängiger, zueinander senkrechter Magnetfeldgradienten der Richtungen x, y und z gemäß dem Koordinatenkreuz 6 vorgesehen sind. In Fig. 1 sind der Übersichtlichkeit halber die Gradientenspulen 7 und 8 gezeichnet, die zusammen mit einem Paar gegenüberliegender, gleichartiger Gradientenspulen zur Erzeugung eines Gradienten in x-Richtung dienen. Die gleichartigen, nicht gezeichneten Gradientenspulen zur Erzeugung eines Gradienten in y-Richtung liegen parallel zum Körper 5 und oberhalb sowie unterhalb von ihm, die Gradientenspulen für das Gradientenfeld in z-Richtung liegen quer zu seiner Längsachse am Fuß- und am Kopfende. Die Anordnung enthält außerdem noch einen zur Erzeugung der Kernresonanzsignale dienenden Körper-Resonator als Antenne. Zur Aufnahme der Kernresonanzsignale ist eine Oberflächenspule 19 vorgesehen, die alternativ zum Körper-Resonator 9 auch zur Erzeugung der Kernresonanzsignale dienen kann.

Das eigentliche Untersuchungsinstrument besteht aus den von einer strichpunktierten Linie 10 umgrenzten Spulen 1, 2, 3, 4, 7 und 8 sowie dem Körper-Resonator 9 und der Oberflächenspule 19. Zum Betrieb der Spulen 1-4 ist ein Netzgerät vorgesehen. An einer Gradientenstromversorgung 12 liegen die Gradientenspulen 7 und 8 sowie weitere, nicht dargestellte Gradientenspulen an. Ein von einem Prozeßrechner 17 gesteuerter Hochfrequenzsender 14 ist mit dem Körper-Resonator 9 verbunden. Die Oberflächenspule 19 ist über einen Signalverstärker 15 ebenfalls an dem Prozeßrechner 17 gekoppelt, an dem zur Ausgabe eines Bildes ein Bildschirmgerät 18 angeschlossen ist. Die Komponenten 14 und 15 bilden eine Hochfrequenzeinrichtung 16 zur Signalerzeugung und -aufnahme.

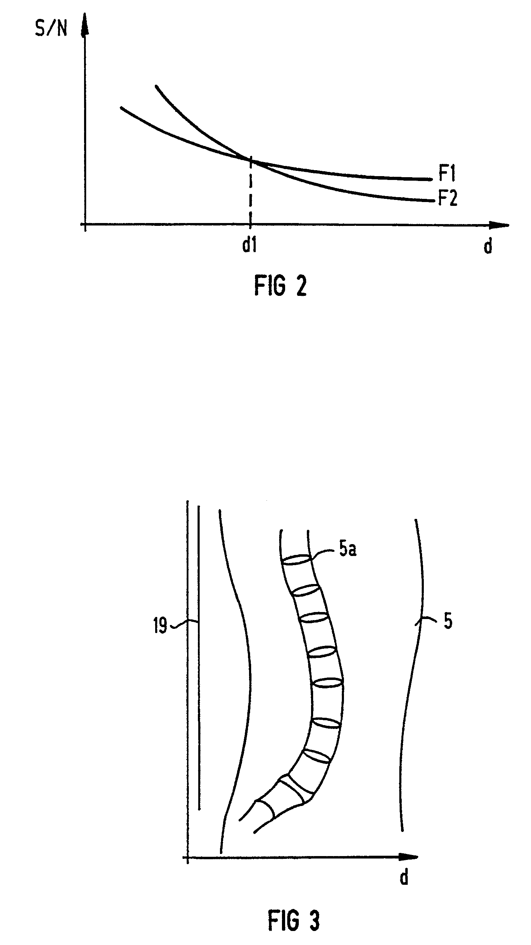

Das der Erfindung zugrundeliegende Problem wird nachfolgend anhand von Fig. 2 näher erläutert. Fig. 2 zeigt die Abhängigkeit des Signal-Rausch-Verhältnisses S/N vom Abstand d Oberflächenspule-Untersuchungsobjekt für zwei unterschiedlich große Oberflächenspulen mit der Fläche $F_1$ bzw. $F_2$. Eine große Oberflächenspule hat einen Empfindlichkeitsverlauf, der sich verhältnismäßig tief in das Untersuchungsobjekt hineinerstreckt, während der Empfindlichkeitsbereich einer kleinen Spule (Fläche $F_2$) weniger weit in der Untersuchungsobjekt hineinverläuft. Entsprechend dem größeren Empfindlichkeitsbereich weist die große Spule in der Nähe der Spulenoberfläche ein schlechteres Signal-Rausch-Verhältnis S/N auf als eine kleine Spule. Umgekehrt wird die kleine Spule bei großen Untersuchungstiefen d ungünstiger bezüglich des Signal-Rausch-Verhältnisses S/N. Im dargestellten Beispiel liegt der Schnittpunkt beider Kurven bei der Untersuchungstiefe $d_1$, d.h. für $d < d_1$ ist die kleine Spule günstiger, für $d > d_1$ ist die große Spule günstiger. Die optimale Fläche der Oberflächenspule hängt also von der Untersuchungstiefe ab.

Fig. 3 zeigt schematisch den Verlauf der Wirbelsäule 5a eines Patienten 5 über der Oberflächenspule 19. Der Abstand zur Oberflächenspule wird dabei mit d bezeichnet, wobei jedoch in Fig. 3 der Übersichtlichkeit wegen ein anderer Maßstab als in Fig. 2 verwendet wird. Dabei wird deutlich, daß die Wirbelsäule 5a, also die "region of interest" keinen gleichmäßigen Abstand von der Oberflächenspule 19 aufweist.

Gemäß der Erfindung soll nun das Tiefenprofil der Oberflächenspule 19 an den jeweiligen Abstand d zur Wirbelsäule 5a angepaßt werden, so daß man jeden Teil der Wirbelsäule mit optimalem Signal-Rausch-Verhältnis SNR abbilden kann.

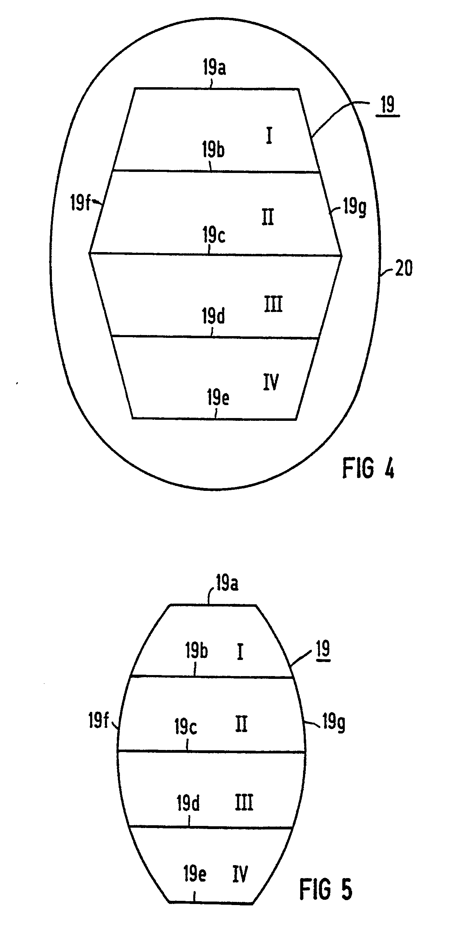

Fig. 4 zeigt hierzu ein erstes Ausführungsbeispiel der Oberflächenspule 19. Die äußere Kontur der Oberflächenspule 19 entspricht der einer an beiden Spitzen abgeflachten Raute. Zwischen den die äußere Kontur der Oberflächenspule 19 bildenden Außenleitern 19f, 19g sind mehrere zueinander parallele Querleiter 19a-19e angeordnet. Durch den Außenleiter 19f, 19g und die Querleiter 19a-19e werden vier Flächenelemente I-IV gebildet, wobei die beiden äußeren Flächenelemente I und IV kleiner sind als die beiden inneren Flächenelemente I und IV.

Die Anordnung der Oberflächenspule 19 bezüglich des Patienten 5 erfolgt so, daß die Wirbelsäule in den Bereichen I und IV einen geringeren Abstand zur Wirbelsäule aufweist als in den Bereichen II und III. Damit ist das Tiefenprofil der Oberflächenspule 19 an den Verlauf der Wirbelsäule angepaßt, so daß jeder Teil der Wirbelsäule mit maximalem Signal-Rausch-Verhältnis S/N abgebildet wird.

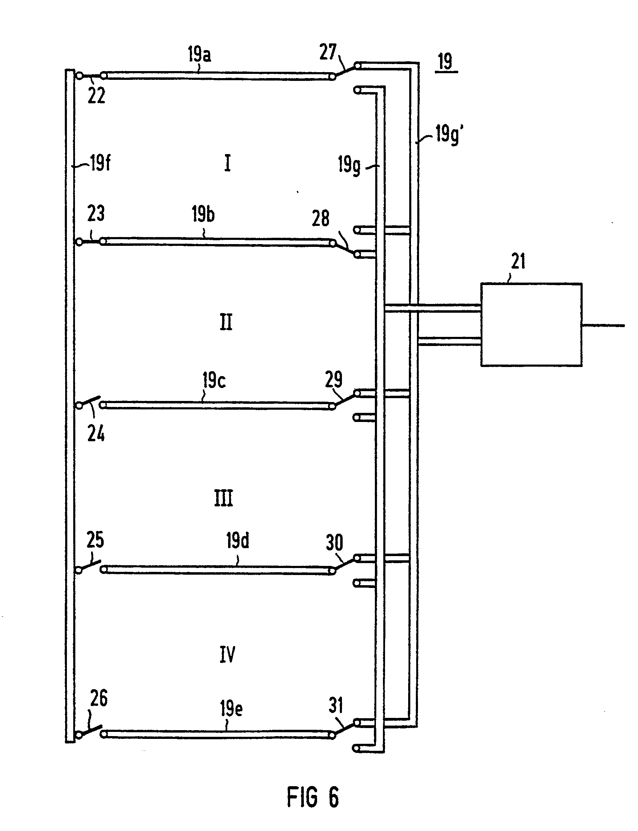

Die zur Aktivierung der Abschnitte I-IV der Oberflächenspule 19 notwendigen Schalter sowie die Ankopplung an eine Empfangseinheit sind in Fig. 4 der Übersichtlichkeit wegen nicht dargestellt und werden in Verbindung mit Fig. 6 später noch näher erläutert.

In Fig. 4 ist die Oberflächenspule außerdem noch von einer Sendespule 20 umgeben. Dabei werden die Kernspins durch Beaufschlagung der Sendespule 20 mit Hochfrequenzimpulsen angeregt, so daß man in diesem Fall auf die Verwendung eines Ganzkörper-Resonators verzichten kann. Damit wird die Hochfrequenz-Belastung des Patienten auf die untersuchte Region begrenzt und die gesamte Hochfrequenz-Belastung wird verringert.

Ein weiteres Ausführungsbeispiel der Erfindung ist in Fig. 5 dargestellt.

Hierbei sind die Außenleiter 19f, 19g im wesentlichen in Form eines Ovals ausgebildet. Es sind ebenfalls zueinander parallele Querleiter 19a-19e vorgesehen, so daß zwischen Außenleitern 19f, 19g und Querleitern 19a-19e wiederum vier Flächenelemente I-IV gebildet werden. Auch das Tiefenprofil dieser Oberflächenspule 19 ist an den Verlauf der Wirbelsäule angepaßt. Auch beim Ausführungsbeispiel nach Fig. 5 sind die im Außenleiter 19f, 19g und in den Querleitern 19a-19e notwendigen Schalter der Übersichtlichkeit wegen weggelassen.

Die elektrische Schaltung der Oberflächenspule ist in Fig. 6 dargestellt. Diese Fig. zeigt nicht die geometrische Anordnung der Oberflächenspule, sondern lediglich deren elektrische Schaltung. Dabei ist ein Ende jedes Querleiters 19a-19e über je einen Schalter 22-26 mit dem Teil 19f des Außenleiters verbunden. Das zweite Ende jedes Querleiters 19a-19e ist über je einen Umschalter 27-31 wahlweise mit einem Teil 19g oder 19g′ des Außenleiters 19f, 19g verbunden. Der Teil 19g ist an einen ersten Anschluß einer Empfangseinheit 21 und der Teil 19g′ des Außenleiters ist mit einem zweiten Anschluß der Empfangseinheit 21 verbunden.

Je nach Stellung der Schalter 22-31 können damit aufeinanderfolgende, unmittelbar aneinander anschließende Abschnitte der Oberflächenspule 19 mit der Empfangsstufe 21 verbunden werden, so daß im Ausführungsbeispiel eines oder mehrere der Flächenelemente I-IV, die eine unterschiedliche Größe aufweisen, aktiv geschaltet werden können.

Im dargestellten Ausführungsbeispiel sind beispielsweise die Schalter 22 und 23 geschlossen und das zweite Ende des Querleiters 19a bzw. 19b ist über den Umschalter 27 an den zweiten Anschluß der Empfangseinheit 21 bzw. über den Umschalter 28 an den ersten Anschluß der Empfangseinheit 21 angeschlossen. Damit ist der an den Querleiter 19a und 19b sowie von Teilen der Außenleiter 19f und 19g' eingeschlossene Abschnitt I der Oberflächenspule 19 mit der Empfangseinheit 21 verbunden. Durch entsprechende Ansteuerung der Schalter 22-31 kann man nacheinander die Abschnitte I-IV an die Empfangseinheit 21 anschließen und somit ohne Bewegung des Patienten oder der Oberflächenspule zumindest einen großen Teil der Wirbelsäule abbilden. Das Tiefenprofil ist jeweils optimiert d.h. jeder Teil der Wirbelsäule wird mit maximalem Signal-Rausch-Verhältnis abgebildet. Wenn man die in Fig. 4 dargestellte Antenne als Sendeantenne verwendet, erfolgt nur in der "region of interest" eine Hochfrequenzbelastung.

Durch die Fortschaltung relativ kleiner Abschnitte der Oberflächenspule wird eine geringe Empfindlichkeitstiefe erzielt. Damit werden atmungsbedingte Bewegungsartefakte, die hauptsächlich durch die Bewegung der Bauchdecke verursacht werden, weitgehend unterdrückt.

**Ansprüche**

1. Oberflächenspule für ein Kernspin-Resonanzgerät zur Ermittlung von Spektren oder Bildern mittels der kernmagnetischen Resonanz mit Spulen (1, 2, 3, 4, 7, 9) zum Anlegen von magnetischen Grund- und Gradientenfeldern an ein Untersuchungsobjekt (5) und mit einer Antenne (9), mit der das Untersuchungsobjekt (5) mit einer Folge von Hochfrequenzimpulsen bestrahlt wird, wobei die vom Untersuchungsobjekt (5) ausgesandten Kernresonanzsignale mit einer Oberflächenspule (19) erfaßt werden, die an eine Auswerteschaltung (15) angeschlossen ist und wobei die Oberflächenspule (19) aus mehreren Leiterabschnitten (19a-19g) besteht, die über Schalter (22-31) so miteinander und mit der Abstimmeinheit (21) verbindbar sind, daß die je nach Stellung der Schalter (19a-19g) mit der Abstimmeinheit (21) verbundenen Leiterabschnitte unterschiedliche Flächen einschließen, **dadurch gekennzeichnet,** daß die von der Oberflächenspule (19) insgesamt umfaßte Fläche eine Breite aufweist, die sich über die Länge der Oberflächenspule (19) ändert.

2. Oberflächenspule nach Anspruch 1, **dadurch gekennzeichnet,** daß die Breite der von der Oberflächenspule (19) insgesamt umfaßten Fläche von deren Mitte aus nach beiden Richtungen abnimmt.

3. Oberflächenspule nach Anspruch 2, **dadurch gekennzeichnet,** daß die Oberflächenspule (19) Außenleiter (19f, 19g) umfaßt, die im wesentlichen in Form eines Ovales gebogen sind und zwischen denen mehrere zueinander parallele Querleiter (19a-19e) angeordnet sind, die durch Schalter (22-31) mit den Außenleitern (19f, 19g) verbindbar sind.

4. Oberflächenspule nach Anspruch 3, **dadurch gekennzeichnet,** daß die Oberflächenspule (19) Außenleiter umfaßt, die im wesentlichen in Form eines Trapezes gebogen sind, und zwischen denen mehrere zueinander parallele Querleiter (19a-19e) angeordnet sind, die durch Schalter (22-31) mit den Außenleitern (19f, 19g) verbindbar sind.

5. Oberflächenspule nach einem der Ansprüche 1 bis 4, **dadurch gekennzeichnet,** daß die gesamte Fläche der Oberflächenspule (19) von einer Sendespule (20) umgeben ist.

FIG 1

S/N

F1
F2

d1

d

FIG 2

19

5a

5

d

FIG 3

19a

I

19

19b

19f

II

19g

19c

III

20

19d

IV

19e

**FIG 4**

19a

19b    I

19

19f

19c    II

19g

19d    III

19e    IV

**FIG 5**

EP 0 394 508 A1

FIG 6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A,D | EP-A-0 280 908 (SIEMENS AG) <br> * Spalte 1, Zeile 33 - Spalte 2, Zeile 12; Spalte 3, Zeilen 38-49; Spalte 4, Zeilen 13-50; Figuren 2,3 * <br> --- | 1,5 | G 01 R 33/34 |
| A | US-A-4 793 356 (G.J. MISIC et al.) <br> * Spalte 6, Zeile 52 - Spalte 7, Zeile 64; Figuren 4C,5C,6C * <br> --- | 1,2,4 | |
| A | GB-A-2 159 626 (JEOL LTD) <br> * Seite 1, Zeile 115 - Seite 2, Zeile 104; Seite 3, Zeilen 38-65; Figur 1 * <br> --- | 1 | |
| A | US-A-4 717 881 (D.C. FLUGAN) <br> * Spalte 3, Zeilen 3-68; Figur 2 * <br> --- | 1 | |
| A | EP-A-0 175 129 (GENERAL ELECTRIC CO.) <br> * Seite 2, Zeile 26 - Seite 3, Zeile 2; Seite 7, Zeile 3 - Seite 11, Zeile 11; Figur 3 * <br> ----- | 1 | |

**RECHERCHIERTE SACHGEBIETE (Int. Cl.5)**

G 01 N
G 01 R

Der vorliegende Recherchenbericht wurde für alle Patentansprüche erstellt

| Recherchenort | Abschlußdatum der Recherche | Prüfer |
|---|---|---|
| DEN HAAG | 27-12-1989 | HORAK G.I. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
............................................................
& : Mitglied der gleichen Patentfamilie, übereinstimmendes Dokument

EPO FORM 1503 03.82 (P0403)